# EUROPEAN PATENT APPLICATION

(11) **EP 3 376 339 A1**
(43) Date of publication of application: **19.09.2018**
(21) Application number: 15908300.5
(22) Date of filing: 11.11.2015
(51) Int. Cl.: G06F 1/20, H05K 7/20

(54) **ELECTRONIC DEVICE COOLING SYSTEM**

(71) Applicant: Exascaler Inc., Tokyo 101-0052 (JP)
(72) Inventor: SAITO, Motoaki, Tokyo 101-0062 (JP)
(74) Representative: Goddar, Heinz J.
(86) International application number: PCT/JP2015/081792
(87) International publication number: WO 2017/081780

(57) **Abstract**

A cooling system 400 configured to directly cool an electronic device immersed in a coolant includes a cooling tank 50 containing the coolant C, and a leakage receiving portion 21 disposed between the cooling tank 50 and a floor surface 32 so as to receive the coolant L leaked from the cooling tank 50. The cooling tank 50 includes a lower structure 53 fixed to the floor surface 32, an upper structure 51 having the electronic device immersed in the coolant C, and a seismic isolation device 55 disposed between the lower structure 53 and the upper structure 51. It is possible to provide the cooling system which is highly durable against externally exerted strong impact and vibration caused by such disaster as earthquake.

## Description

### Technical Field

The present invention relates to a cooling system for electronic devices. More specifically, the present invention relates to the cooling system for electronic devices, which is configured to efficiently cool the electronic devices such as the supercomputer, and the data center which are required to exert super-high performances and stable operations while generating the high heating value.

### Background Art

Conventionally, the process for cooling the supercomputer and the data center has been performed through two different methods, that is, the air cooling method and the liquid cooling method. In general, the cooling efficiency of the liquid cooling method is better than that of the air cooling method because liquid exhibits higher heat transfer performance than air. For example, the liquid immersion cooling system using synthetic oil has been employed for the supercomputer called "TSUBAME-KFC" constructed by Tokyo Institute of Technology. However, the use of the synthetic oil with high viscosity for the liquid coolant causes difficulty in complete removal of the oil adhering to the electronic device when it is taken from the oil immersion rack. This may be an obstacle to the maintenance work for the electronic device (specifically, for example, adjustment, inspection, repair, replacement, extension). Furthermore, the trouble in the operation caused by the synthetic oil leakage has been reported. Specifically, the synthetic oil in use will corrode the packing or the like that constitutes the cooling system in a short period of time, resulting in the synthetic oil leakage.

The liquid immersion cooling system using the fluorocarbon-based coolant instead of the synthetic oil as the causes of the above-described problem has been proposed. Specifically, the use of the fluorocarbon-based coolant (hydrofluoroether (HFE) compound manufactured by 3M called "Novec (trademark of 3M) 7100", "Novec 7200", "Novec 7300") is exemplified (for example, Patent Literatures 1 and 2).

The applicant has already developed the compact liquid immersion cooling system with excellent cooling efficiency suitable for the supercomputer of small-scale liquid immersion cooling type. The system employs the fluorocarbon-based coolant formed from the complete fluoride. Such system applied to the compact super computer "Suiren" installed in the high-energy accelerator research organization has been in operation (Non-patent Literature 1).

### Citation List

### Patent Literature

Patent Literature 1: Japanese Patent Application Laid-Open No. 2013-187251
Patent Literature 2: Japanese Translation of PCT International Application Publication No. 2012-527109

Non-Patent Literature 1: "Liquid immersion cooling compact supercomputer "ExaScaler-1" succeeded in measurement of the value corresponding to the world highest level of the latest supercomputer power consumption performance ranking "Green500" resulting from the performance improvement by 25 % or higher" March 31, 2015, Press Release, ExaScaler Inc., et al., URL:http://exascaler.co.jp/wp-content/uploads/2015/03/20150331.pdf

### Summary of Invention

### Technical Problem

In the case of either the synthetic oil, the fluorocarbon-based coolant, or the complete fluoride used as the coolant for the cooling system of liquid cooling type, a large volume of the coolant is consumed for cooling a plurality of electronic devices in the cooling tank. In the case of breakage of a part of the cooling system (for example, joint part between the inlet or outlet for the coolant, and the piping in the cooling tank) caused by strong impact or vibration owing to such disaster as earthquake or unpredictable accident, a large volume of coolant may leak out through the broken part. In most cases, the material used as the coolant for liquid immersion cooling is a nonvolatile liquid at normal temperature. Therefore, once such coolant leaks out, it is extremely difficult to collect the leaked coolant.

As the coolant such as the complete fluoride is generally expensive, even if the leaked coolant is collected, the economic loss owing to non-reusability of the collected coolant may cause serious problems.

On the other hand, from the perspective of preventing the accidental coolant leakage caused by the disaster and accident, there has been a demand for the cooling system highly durable against the strong external impact and vibration especially caused by such disaster as earthquake.

It is an object of the present invention to provide the cooling system which facilitates collection of the accidentally leaked coolant.

It is another object of the present invention to provide the cooling system capable of suppressing the height dimension of the device for temporarily accumulating the leaked coolant until it is collected.

It is still another object of the present invention to provide the cooling system that is highly durable against the externally exerted strong impact and vibration caused by such disaster as earthquake. Solution to Problem

According to an aspect of the present invention, provided for solving the above-described problem is a cooling system configured to directly cool an electronic device immersed in a coolant, which includes a cooling tank containing the coolant, a leakage receiving portion disposed between the cooling tank and a floor surface so as to receive the coolant leaked from the cooling tank, an additional leakage receiving portion disposed to receive the coolant overflown from the leakage receiving portion which stores the leaked coolant by a volume in excess of a predetermined volume, and a passage that connects the leakage receiving portions for passing the overflown coolant by the volume in excess of the predetermined volume.

In a preferred embodiment of the cooling system according to the present invention, the additional leakage receiving portion may include an additional cooling tank separately from the cooling tank.

In a preferred embodiment of the cooling system according to the present invention, the cooling system may further include a heat exchanger for cooling the coolant outside the cooling tank, the coolant having been warmed in the cooling tank, which allows the additional leakage receiving portion to be disposed between the heat exchanger and an installation surface thereof.

In a preferred embodiment of the cooling system according to the present invention, the floor surface and the installation surface may be configured to serve as upper and lower parts of a raised bottom structure in two stages, and the passage pierces through the floor surface.

In a preferred embodiment of the cooling system according to the present invention, the leakage receiving portion may be configured to include a distribution plate for distributing a load applied from the cooling tank, and a closed side wall disposed on the distribution plate to enclose the cooling tank.

In a preferred embodiment of the cooling system according to the present invention, each of the leakage receiving portions further may include a lid member for covering each upper opening of the leakage receiving portions.

In a preferred embodiment of the cooling system according to the present invention, the cooling tank may be configured to include a lower structure fixed to the floor surface, an upper structure having the electronic device immersed in the coolant, and a seismic isolation device disposed between the lower structure and the upper structure.

In a preferred embodiment of the cooling system according to the present invention, the lower structure includes a dispenser for dispensing a cold coolant. The upper structure includes a plurality of inflow pipes that allow the dispensed cold coolant to flow into the cooling tank. Each of the inflow pipes is connected to the dispenser with a flexible pipe.

In a preferred embodiment of the cooling system according to the present invention, the upper structure includes a plurality of outflow pipes which allow the coolant that has been warmed in the cooling tank to flow out from the cooling tank. The lower structure includes a collector for collecting the warmed coolant. Each of the outflow pipes is connected to the collector with a flexible pipe.

In a preferred embodiment of the cooling system according to the present invention, the lower structure includes an inlet passage for passing the cold coolant. The upper structure includes a dispenser for dispensing the cold coolant, and a plurality of inflow pipes that allow the dispensed cold coolant to flow into the cooling tank. The inlet passage and the dispenser are connected with a flexible pipe.

In a preferred embodiment of the cooling system according to the present invention, the upper structure includes a plurality of outflow pipes that allow the coolant that has been warmed in the cooling tank to flow out from the cooling tank, and a collector for collecting the warmed coolant. The lower structure includes an outlet passage for passing the warmed coolant. The collector and the outlet passage are connected with a flexible pipe.

Additionally, according to another aspect of the present invention, the cooling system configured to directly cool an electronic device immersed in a coolant includes a cooling tank containing the coolant, and a leakage receiving portion disposed between the cooling tank and a floor surface so as to receive the coolant leaked from the cooling tank. The leakage receiving portion includes a distribution plate for distributing a load applied from the cooling tank, a closed side wall disposed on the distribution plate to enclose the cooling tank, and a lid member for covering an upper opening between the closed side wall and the cooling tank.

According to another aspect of the present invention, the cooling system configured to directly cool an electronic device immersed in a coolant includes a cooling tank containing the coolant, and a leakage receiving portion disposed between the cooling tank and a floor surface so as to receive the coolant leaked from the cooling tank. The cooling tank includes a lower structure fixed to the floor surface, an upper structure having the electronic device immersed in the coolant, and a seismic isolation device disposed between the lower structure and the upper structure.

### Advantageous Effects of Invention

According to an aspect of the present invention, it is possible to provide the cooling system which facilitates collection of the accidentally leaked coolant.

According to another aspect of the present invention, it is possible to provide the cooling system capable of suppressing the height dimension of the device for temporarily accumulating the leaked coolant until it is collected.

According to still another aspect of the present invention, it is possible to provide the cooling system which is highly durable against externally exerted strong impact and vibration caused by such disaster as earthquake.

The above-described or any other objects and advantages will be clearly understood in reference to the following description of the embodiments. The description herein is for an illustrative purpose, and therefore, the present invention is not limited to those embodiments. Brief Description of Drawings

Figure 1 is a plan view of a cooling system according to an embodiment of the present invention.
Figure 2 is a side view of the cooling system according to the embodiment of the present invention.
Figure 3 is a side view of the cooling system according to the embodiment of the present invention.
Figure 4 is a side view of the cooling system according to another embodiment of the present invention.
Figure 5 is a perspective view of the cooling system according to another embodiment of the present invention.
Figure 6 is a side view of the cooling system according to another embodiment of the present invention.
Figure 7 is a side view of the cooling system according to another embodiment of the present invention.

### Description of Embodiments

Preferred embodiments of the cooling system according to the present invention will be described in detail based on the drawings.

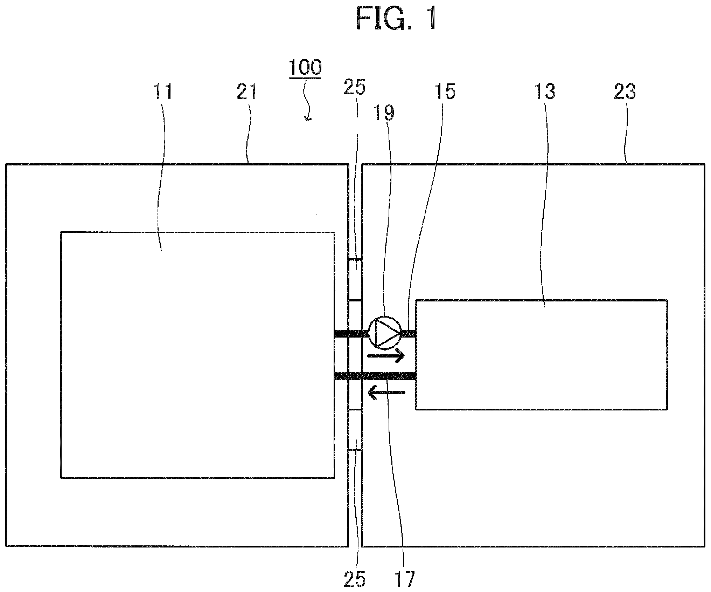

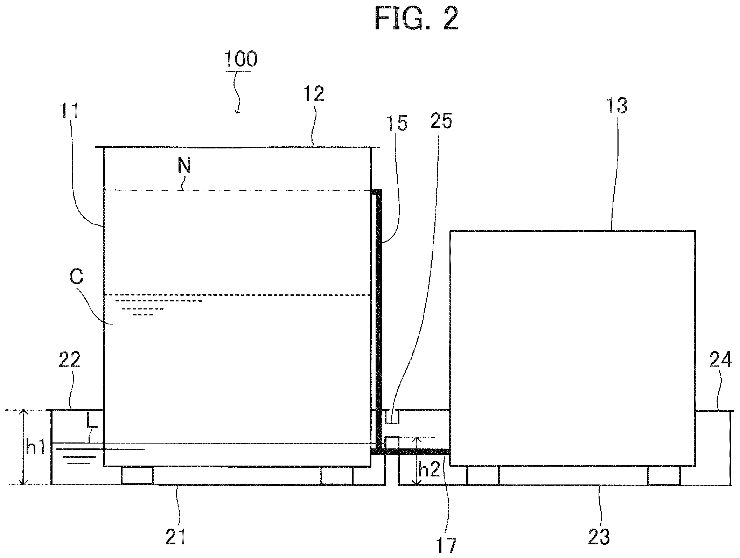

Referring to Figures 1 and 2, a cooling system 100 according to an embodiment includes a cooling tank 11 containing a coolant C, a leakage receiving portion 21 disposed between the cooling tank 11 and a floor surface, another leakage receiving portion 23 disposed between a heat exchanger 13 and an installation surface, and a passage 25 for connecting the leakage receiving portions 21 and 23. A plurality of electronic devices (not shown) are immersed in the coolant C that circulates in the cooling tank 11 so as to be directly cooled. Preferably, the cooling tank 11 has an open space. The cooling tank 11 having the "open space" described in the specification includes the cooling tank with a simple sealing structure sufficient to secure maintainability of the electronic device. The simple sealing structure refers to the one that allows a top plate 12 to be openably or detachably mounted onto the opening of the cooling tank 11 via a packing or the like.

The heat exchanger 13 is configured to cool the coolant C outside the cooling tank 11, which has been warmed as a result of taking heat from the electronic devices in the cooling tank 11. For example, it is possible to use various types of heat exchanger (so called radiator, chiller, cooling tower) including a condenser of air cooling type, water cooling type, or evaporation type, for example. The coolant C which has been warmed and discharged from the outlet formed at the upper part of the cooling tank 11 passes through a flow passage 15, and is fed by a pump 19 under pressure toward the heat exchanger 13. The coolant C which is cooled by the heat exchanger 13 is introduced into an inlet (not shown) formed in the bottom of the cooling tank 11 while passing through a flow passage 17.

The leakage receiving portion 21 may be constituted by a distribution plate for distributing the load applied from the cooling tank 11, and a closed side wall (height: h1) disposed on the distribution plate to enclose the cooling tank 11. Upon leakage of the coolant C from the cooling tank 11 (including the flow path of the coolant C such as the flow passages 15 and 17 attached to the bottom or the side part of the cooling tank 11), the leakage receiving portion is configured to receive the leaked coolant L. The leakage receiving portion 21 may further include a lid member 22 that covers the upper opening. The lid member 22 is effective to prevent mixture of the foreign substance in the coolant L leaked from the opening, and to facilitate the access to the cooling tank 11 by closing the upper opening.

The other leakage receiving portion 23 is disposed to receive the coolant L overflown from the leakage receiving portion 21 for accumulating the leaked coolant by the volume in excess of the predetermined volume. The predetermined volume may be set by adjusting the area of the distribution plate, and the height h2 from the floor surface (more correctly, the surface of the distribution plate disposed on the floor surface) to the lowermost part of the passage 25 (in the example shown in Figure 2, the floor surface is on the same horizontal plane as the surface on which the heat exchanger 13 is disposed). The other leakage receiving portion 23 may also include a lid member 24 for covering the upper opening. Especially, in the case where the heat exchanger 13 is disposed outdoors, the use of the lid member 24 is essential for preventing mixture of the foreign substance.

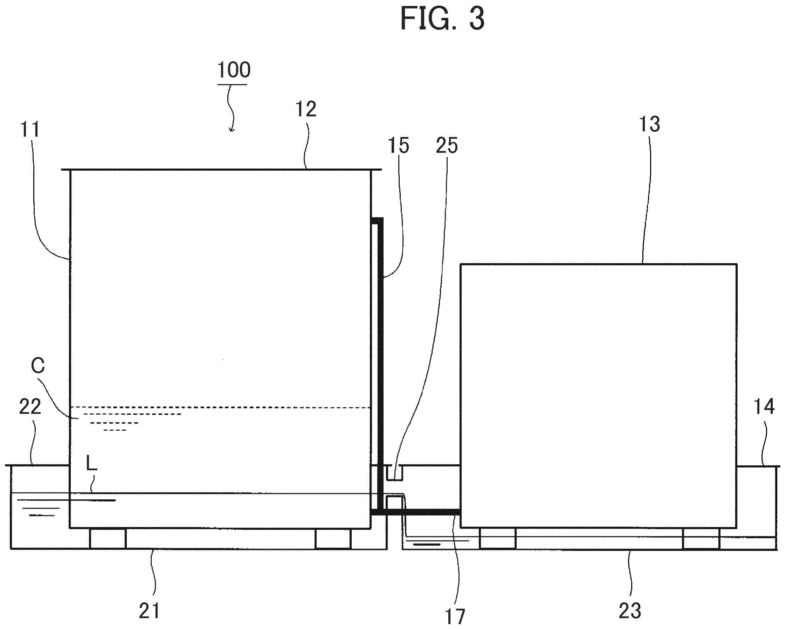

Referring to Figure 3, the passage 25 passes the overflown coolant L by the volume in excess of the predetermined volume from the leakage receiving portion 21 to the other leakage receiving portion 23. The leaked coolant L is kept accumulated in the leakage receiving portion 21 until the volume of the leaked coolant L reaches the predetermined volume. In the case of a small volume of leakage, the coolant may be collected at the single location. Meanwhile, in the case of a large volume of leakage, that is, the leaked volume of the coolant L exceeds the predetermined volume, the overflown coolant L in excess of the predetermined volume passes through the passage 25 so as to be accumulated in the other leakage receiving portion 23. The coolant has to be collected at two locations. As the sum of the installation areas of the leakage receiving portions 21 and 23 becomes the total installation area, it is possible to keep each area of the respective installation areas of the leakage receiving portions 21 and 22 small, and the height h1 of the side wall low. It is therefore possible to assemble the cooling system by connecting the installed leakage receiving portions 21 and 23 using the passage 25. Compared with assembly of the cooling system configured to use the single leakage receiving portion for receiving the whole volume of the leaked coolant L, the cooling system in the above-described case may be assembled by inserting the leakage receiving portion 21 with small area, which is short in height into the building. This makes it possible to significantly lessen difficulties in loading and installation works.

Preferably, the passage 25 may be made of a flexible pipe, having both ends rigidly fixed to the side wall of the leakage receiving portion 21 and the side wall of the other leakage receiving portion 23 using fasteners. Referring to the example as shown in Figures 1 to 3, the heat exchanger 13 is disposed on the other leakage receiving portion 23. It is possible to dispose another cooling tank (having the similar structure to that of the cooling tank 11, with which the coolant C is filled) separately from the cooling tank 11 instead of using the heat exchanger 13. In the above-described case, it is possible to accumulate the coolant L leaked from the thus provided cooling tank in the other leakage receiving portion 23 up to the predetermined volume. If the volume of the leaked coolant L that has been accumulated in the other leakage receiving portion 23 exceeds the predetermined volume set for the leakage receiving portion 23, the leaked coolant L by the volume in excess of the predetermined volume passes through the passage 25 so as to be accumulated in the leakage receiving portion 21. The structure similar to the one as described above may be applied to the cooling system including the third or more cooling tanks in addition to the cooling tank 11 and the other cooling tank. In such a case, it is possible to dispose the third or more cooling tanks corresponding to the third or more leakage receiving portions, respectively. The leakage receiving portions 21, 23, the third or more leakage receiving portions may be arbitrarily combined, and connected via the passages. For example, it is possible to arrange 3 or more leakage receiving portions corresponding to the respective cooling tanks longitudinally or laterally in a row, and to connect adjacent leakage receiving portions via the passage.

The cooling tank 11 contains the coolant C sufficient to immerse the entire bodies of the electronic devices (not shown) up to the liquid surface N in the normal state. It is preferable to use a fluorine-based inert liquid formed of the complete fluoride (perfluorocarbon compound) well known as "Fluorinert (trademark of 3M Japan Products Limited) FC-72" (boiling point: 56°C), "Fluorinert FC-770" (boiling point: 95°C), "Fluorinert FC-3283" (boiling point 128°C), "Fluorinert FC-40" (boiling point: 155°C), "Fluorinert FC-43" (boiling point: 174°C), all of which are manufactured by 3M Japan Products Limited. However, it is possible to use the synthetic oil, low volatile fluorocarbon-based coolant or the like in a non-restrictive way.

Focusing on the complete fluoride that exhibits excellent characteristics such as high electric insulation, high heat transfer capacity, inertness and high thermal/chemical stability, incombustibility, and zero ozone depletion potential derived from the oxygen-free compound, the applicant has filed the patent application relating to the cooling system configured to use the coolant that contains the complete fluoride as the main component as the refrigerant for immersion cooling of the highly densified electronic devices (Japanese Patent Application No. 2014-170616). As disclosed in the prior art, the use of Fluorinert FC-43 or FC-40 as the coolant is significantly advantageous for efficiently cooling the electronic devices disposed with high density in the cooling tank 11 of a small volume, while remarkably suppressing the loss of the coolant C due to evaporation from the cooling tank 11 with the open space.

Fluorinert FC-43 or FC-40 has the boiling point equal to or higher than 150°C, which hardly evaporates. It is possible to attach the top plate 12 onto the upper opening of the cooling tank 11 detachably or openably so as to facilitate the maintenance of the electronic device (not shown). For example, it is possible to support the top plate 12 openably using a not shown hinge attached to one edge of the upper opening of the cooling tank 11.

The explanation has been made with respect to an example of the cooling system according to the embodiment as shown in Figures 1 to 3, which is configured to have the leakage receiving portions 21 and 23 disposed on substantially the same horizontal plane, and to connect those leakage receiving portions via the passage 25. It is also possible to provide an additional leakage receiving portion on the installation surface at the level lower than the floor surface on which the leakage receiving portion is disposed.

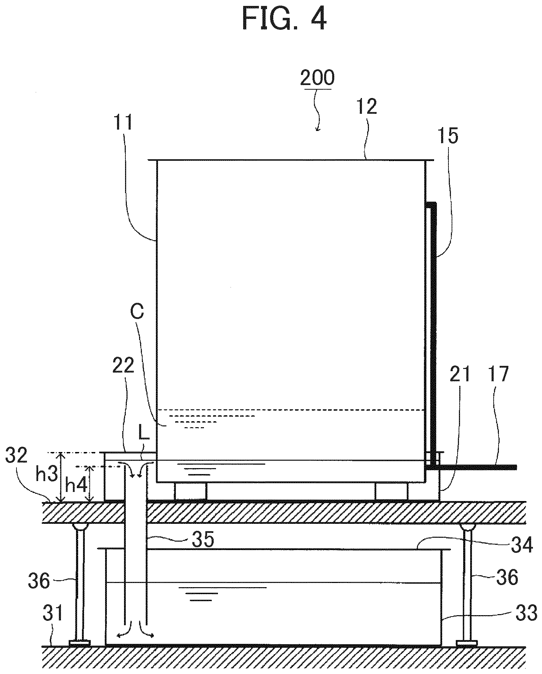

Figure 4 shows a cooling system 200 according to another embodiment of the present invention, indicating an exemplary structure having an additional leakage receiving portion disposed on the installation surface at the height lower than the floor surface on which the leakage receiving portion is disposed. The same components as those of the cooling system 100 will be designated with the same codes. The cooling system 200 according to the embodiment includes a floor surface 32 and an installation surface 31 which serve as upper and lower parts of a raised bottom in two stages. The leakage receiving portion 21 is disposed between the floor surface 32 and the cooling tank 11. An additional leakage receiving portion 33 is disposed on the installation surface 31. The floor surface 32 is supported with a plurality of posts 36 at the fixed height from the installation surface 31. The additional leakage receiving portion 33 is disposed in the space between the installation surface 31 and the floor surface 32.

A passage 35 (which may be made of the flexible pipe) is structured to pierce through the distribution plate of the leakage receiving portion 21 and the floor surface 32, while having one end located in the leakage receiving portion 21, and the other end located in the additional leakage receiving portion 33. If the volume of the coolant L overflown from the leakage receiving portion 21 which accumulates the leaked coolant L exceeds a predetermined volume, the additional leakage receiving portion 33 is structured to receive the overflown coolant L flowing down through the passage 35. The predetermined volume may be set by adjusting the area of the distribution plate, and a height h4 from the floor surface (more correctly, the surface of the distribution plate disposed on the floor surface) to one end of the passage 35. A lid member 34 for covering the upper opening may be provided for the additional leakage receiving portion 33.

In the embodiment, increase in the capacity of the additional leakage receiving portion 33 positioned in the space between the installation surface 31 and the floor surface 32 may reduce the capacity of the leakage receiving portion 21. This ensures to make the area of the distribution plate smaller, or make the height h3 of the side wall lower. Accordingly, it is significantly advantageous in minimization of the capacity of the leakage receiving portion 21.

Meanwhile, if it is possible to secure the wide area sufficient to accommodate installation of the leakage receiving portion 21, only one leakage receiving portion with relatively large capacity may be used by omitting the other leakage receiving portions 23, 33.

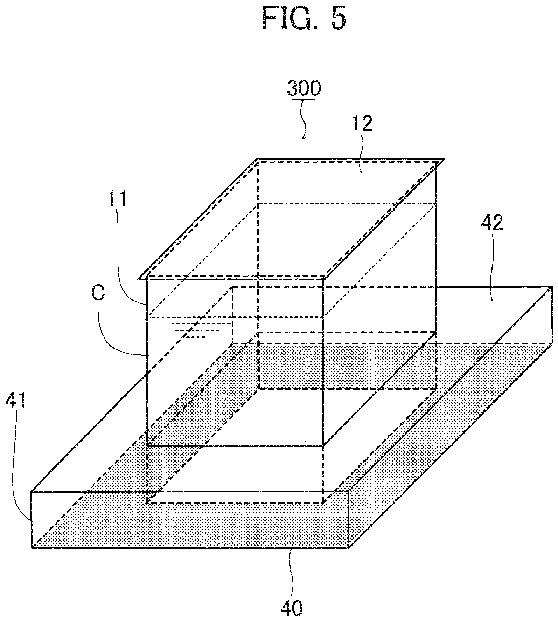

Figure 5 shows a cooling system 300 according to another embodiment of the present invention, which includes a leakage receiving portion 41 disposed between the cooling tank 11 and the floor surface so as to receive the coolant leaked from the cooling tank 11. The leakage receiving portion 41 includes a distribution plate 40 for distributing the load applied from the cooling tank 11, a closed side wall that is disposed on the distribution plate 40 to enclose the cooling tank 11, and a lid member 42 for covering the upper opening between the closed side wall and the cooling tank 11. It is the most preferable to set the capacity of the leakage receiving portion 41 sufficient to entirely receive the maximum possible volume of the coolant leaked from the cooling tank 11. The bottom surface of the leakage receiving portion 41 in contact with the floor surface serves as the distribution plate with wide area so that the load applied from the cooling tank 11 is distributed over the wide area. Additionally, the height of the side wall of the leakage receiving portion 41 may be kept low. The above-described features are the greatest advantages of the embodiment.

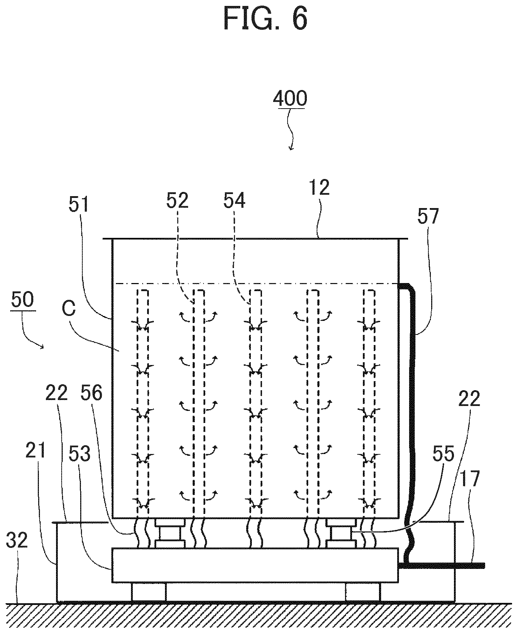

Referring to Figure 6, a cooling system 400 according to another embodiment has the cooling tank divided into a plurality of housing parts (for example, 4 x 4 = 16), each of which accommodates one or more electronic devices for housing and cooling. It is exemplified as the high density cooling system exhibiting the seismic isolation function. The same components as those of the cooling system 100 are designated with the same codes. The cooling system 400 according to the embodiment includes a cooling tank 50 containing the coolant, and the leakage receiving portion 21 disposed between the cooling tank 50 and the floor surface so as to receive the coolant leaked from the cooling tank 50. The cooling tank 50 includes a lower structure 53 fixed to the floor surface 32, an upper structure 51 in which the electronic devices (not shown) are immersed in the coolant C, and a seismic isolation device 55 disposed between the lower structure 53 and the upper structure 51. The bottom of the leakage receiving portion 21 in contact with the floor surface 32 may serve as the distribution plate for distributing the load applied from the cooling tank 50 in the similar way to the above-described embodiment. The leakage receiving portion 21 may be constituted by the distribution plate, the closed side wall disposed on the distribution plate to enclose the cooling tank 50, and the lid member 22 for covering the upper opening between the closed side wall and the cooling tank 50.

The lower structure 53 includes a dispenser (not shown) for dispensing the cold coolant C. The upper structure 51 includes a plurality of inflow pipes 52 each allowing the dispensed cold coolant C to flow into the cooling tank 50. The inflow pipes 52 may be disposed separately at predetermined intervals while extending upward from the bottom of the upper structure 51 of the cooling tank 50. The inflow pipes 52 and the dispenser (not shown) are connected using flexible pipes 56, respectively.

Furthermore, the upper structure 51 includes a plurality of outflow pipes 54 which allow outflow of the coolant C that has been warmed in the cooling tank 50. The lower structure 53 includes a collector (not shown) for collecting the warmed coolant C. The outflow pipes 54 may be disposed separately at predetermined intervals while extending upward from the bottom of the upper structure 51 of the cooling tank 50. Each of the outflow pipes 54 is connected to the collector using the flexible pipe 56. A flow passage 57 extending from the outlet formed at the upper part of the cooling tank 50 is also made of the flexible pipe.

The dispenser (not shown) and the inflow pipes 52, and the collector (not shown) and the outflow pipes 54 may be disposed alternately in the depth direction of the cooling tank 50, respectively. This makes it possible to prevent each cooling performance from becoming different among the electronic devices housed in the cooling tank 50 with high density depending on the housed position.

Operations of the cooling system 400 according to the embodiment will be described. Concerning the flow path of the coolant C, after passing through the flow passage 17, and flowing into the lower structure 53 of the cooling tank 50 through the inlet, the cold coolant C passing from the dispenser through the inflow pipes 52 via the flexible pipes 56 is discharged from a plurality of small holes formed in the side surfaces of the respective inflow pipes 52. The warmed coolant C as a result of taking heat from the electronic devices partially flows into the outflow pipes 54 while passing through the small holes formed in the side surfaces of the outflow pipes 54. It then flows into the collector (not shown) within the lower structure 53 via the flexible pipes 56, and flows out through the outlet of the lower structure 53 while passing through the flow passage (corresponding to the flow passage 15 as shown in Figure 1). The rest of the warmed coolant C flows out through the flow passage 57 from the outflow opening formed in the upper side wall surface of the cooling tank 50.

On the assumption that the leakage receiving portion 21 on the floor surface 32 and the lower structure 53 of the cooling tank 50 are shaken by an earthquake, the seismic isolation device 55 disposed between the lower structure 53 and the upper structure 51 of the cooling tank 50 is configured to make the vibration of the lower structure 53 less transferable to the upper structure 51. In accordance with the magnitude of vibration, the seismic isolation device 55 serves to make movement of the upper structure 51 slower relative to the lower structure 53. The flow passage between the lower structure 53 and the upper structure 51 is made of the flexible pipe 56 so as to effectively prevent generation of crack or fracture.

Preferably, the seismic isolation device 55 employs the isolator (laminated rubber bearing, sliding bearing, or rolling bearing) for supporting the heavy upper structure 51 of the cooling tank 50. Together with the isolator, the damper (oil damper, steel damper, or lead damper) may be used as needed for stopping vibration of the upper structure 51 at the early stage after the earthquake settles down. The specific structures or functions of various kinds of isolators and dampers employed for the seismic isolation device 55 are well known to those skilled in the art, and detailed explanations thereof, thus will be omitted.

The high density cooling system according to the embodiment as described above ensures to be highly durable against the strong impact and vibration attributing to outside causes, for example, the disaster like earthquake. In the case of the coolant leakage by any chance, the leaked coolant is received by the leakage receiving portion 21 so as to be temporarily accumulated. This makes it possible to facilitate collection of the leaked coolant.

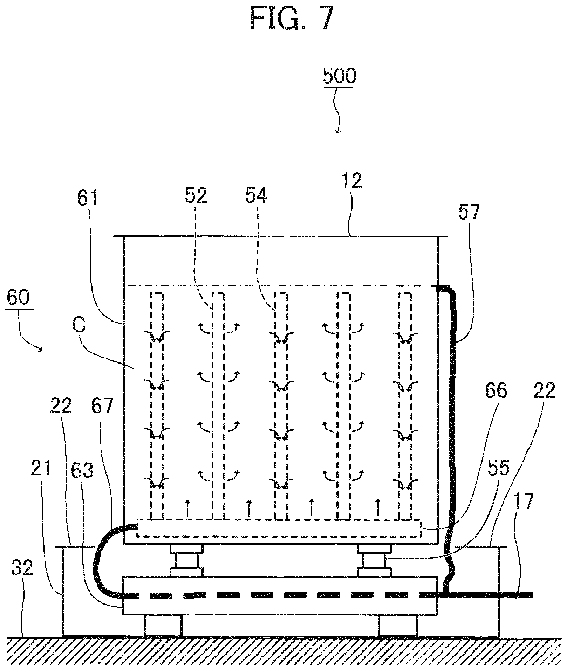

Referring to Figure 7, a cooling system 500 according to another embodiment is exemplified as another type of the high density cooling system having the seismic isolation function likewise the cooling system 400 as shown in Figure 6. The same components as those of the cooling system 400 will be designated with the same codes. The cooling system 500 according to the embodiment includes a cooling tank 60 containing the coolant, and the leakage receiving portion 21 disposed between the cooling tank 60 and the floor surface for receiving the coolant leaked from the cooling tank 60. The cooling tank 60 includes a lower structure 63 fixed to the floor surface 32, an upper structure 61 in which a plurality of electronic devices (not shown) are immersed in the coolant C, and the seismic isolation device 55 disposed between the lower structure 63 and the upper structure 61. The bottom of the leakage receiving portion 21 in contact with the floor surface 32 may serve as the distribution plate for distributing the load applied from the cooling tank 60 likewise the above-described embodiment. The leakage receiving portion 21 may include the distribution plate, the closed side wall disposed on the distribution plate to enclose the cooling tank 60, and the lid member 22 for covering the upper opening between the closed side wall and the cooling tank 60.

The lower structure 63 includes an inlet passage that passes the cold coolant C, and the upper structure 61 includes a dispenser 66 for dispensing the cold coolant C, and the plurality of inflow pipes each allowing the dispensed cold coolant C to flow into the cooling tank 60. The inlet passage and the dispenser 66 are connected with a flexible pipe 67. The flow passage 57 extending from the outlet formed at the upper part of the cooling tank 60 is also made of the flexible pipe.

The upper structure 61 further includes the outflow pipes 54 for discharging the coolant C warmed in the cooling tank 60 with its outer part, and the collector (not shown) for collecting the warmed coolant C. The outflow pipes 54 may be disposed separately at predetermined intervals while extending upward from the bottom of the upper structure 61 of the cooling tank 60. The lower structure 63 includes the outlet passage that passes the warmed coolant C. The collector and the outlet passage are connected using the flexible pipe 67.

Advantages of the cooling system 500 according to the embodiment are similar to those of the above-described cooling system 400, and explanations thereof, thus will be omitted.

The seismic isolation function of the cooling system 400 as shown in Figure 6, or the seismic isolation function of the cooling system 500 as shown in Figure 7 may be imparted to the cooling system 300 as shown in Figure 5. Detailed explanations of structures of the modified example will be omitted as they are analogous to those of the cooling systems 400 and 500 as shown in Figures 6 and 7, respectively.

In the above-described embodiments and modifications thereof, the electronic device may include the processor installed on the board. The processor may be configured to include CPU (Central Processing Unit) and/or GPU (Graphics Processing Unit). The electronic device may include the high-speed memory, chipset, network unit, PCI Express bus, bus switch unit, SSD (Solid State Drive), and power unit (AC-DC converter, DC-DC voltage converter). The electronic device may be the one for the storage unit, for example, server including the blade server, router, and SSD. The high density cooling system is allowed to use the electronic device with the width smaller than the usual width of the generally employed electronic device (for example, approximately 1/2, 1/3, 1/4 of the width).

### Industrial Applicability

The present invention is applicable to the cooling system configured to cool the electronic devices immersed in the coolant. Reference Signs List

100, 200, 300, 400, 500: cooling system,
11, 50, 60: cooling tank,
12: top plate,
13: heat exchanger,
15, 17: flow passage,
19: pump,
21, 41: leakage receiving portion,
23, 33: additional leakage receiving portion,
22, 24, 34, 42: lid member,
25, 35: passage,
31: installation surface,
32: floor surface,
36: post,
40: distribution plate,
51, 61: upper structure,
52: inflow pipe,
53, 63: lower structure,
54: outflow pipe,
55: seismic isolation device,
56, 67: flexible pipe,
57: flexible flow passage,
66: dispenser

## Claims

1. A cooling system configured to directly cool an electronic device immersed in a coolant, the cooling system comprising:
a cooling tank containing the coolant; and
a leakage receiving portion disposed between the cooling tank and a floor surface so as to receive the coolant leaked from the cooling tank, wherein the cooling tank includes a lower structure fixed to the floor surface, an upper structure having the electronic device immersed in the coolant, and a seismic isolation device disposed between the lower structure and the upper structure.

2. The cooling system according to claim 1, wherein:
the lower structure includes a dispenser for dispensing a cold coolant;
the upper structure includes a plurality of inflow pipes that allow the dispensed cold coolant to flow into the cooling tank; and
each of the inflow pipes is connected to the dispenser with a flexible pipe.

3. The cooling system according to claim 1 or 2, wherein:
the upper structure includes a plurality of outflow pipes which allow the coolant that has been warmed in the cooling tank to flow out from the cooling tank;
the lower structure includes a collector for collecting the warmed coolant; and
each of the outflow pipes is connected to the collector with a flexible pipe.

4. The cooling system according to claim 1, wherein:
the lower structure includes an inlet passage for passing the cold coolant;
the upper structure includes a dispenser for dispensing the cold coolant, and a plurality of inflow pipes that allow the dispensed cold coolant to flow into the cooling tank; and
the inlet passage and the dispenser are connected with a flexible pipe.

5. The cooling system according to claim 1 or 2, wherein:
the upper structure includes a plurality of outflow pipes that allow the coolant that has been warmed in the cooling tank to flow out from the cooling tank, and a collector for collecting the warmed coolant;
the lower structure includes an outlet passage for passing the warmed coolant; and
the collector and the outlet passage are connected with a flexible pipe.
